# EUROPÄISCHE PATENTANMELDUNG

(11) **EP 2 660 741 A1**
(43) Veröffentlichungstag der Anmeldung: **06.11.2013**
(21) Anmeldenummer: 13178570.1
(22) Anmeldetag: 22.11.2006
(51) Int. Cl.: G06F 17/50, G06F 17/30, G06F 9/40

(54) **Verfahren zur computergestützen Simulation technischer Prozesse**

(30) Priorität: 02.12.2005 DE 102005057697
(62) Teilanmeldung aus: 06829094.9
(71) Anmelder: Fraunhofer-Gesellschaft zur Förderung der angewandten Forschung e.V., 80686 München (DE)
(72) Erfinder: Klein, Peter, 76857 Wernersberg (DE); Merten, Dirk, 67657 Kaiserslautern (DE)
(74) Vertreter: Pfenning, Meinig & Partner GbR

(57) **Zusammenfassung**

Die vorliegende Erfindung betrifft ein Verfahren zur computergestützten Simulation technischer Prozesse. Derartige Verfahren werden insbesondere bei Evolutionssimulationsmodellen technischer, insbesondere physikalischer und/oder chemischer Prozesse benötigt, die in der Zeit propagiert werden sollen (Evolution). Das erfindungsgemäße Verfahren zur computergestützten Simulation der zeitlichen Propagation technischer Prozesse als Evolutionsproblem, das durch mindestens zwei verschiedene mathematische Modelle als Subevolutionsprobleme beschrieben wird, die voneinander verschiedene, mittels modellspezifischer Algorithmen in der Zeit propagierte Diskretisierungseinheiten verwenden, wobei die Simulation mittels einer Vielzahl von Berechnungseinheiten ausgeführt wird, ist dadurch gekennzeichnet dass die mathematischen Modelle auf eine einzige zusammenhängende Graphenstruktur mit den Diskretisierungseinheiten als Knoten und deren Nachbarschaftsrelationen als Kanten abgebildet werden, wobei sich Kanten zwischen zum gleichen Model gehörigen Diskretisierungseinheiten sowie Kanten zwischen zu verschiedenen Modellen gehörigen Diskretisierungseinheiten ergeben, jeweils für die jeweils einem mathematischen Modell zugeordneten Knoten, für die Kanten zwischen zum gleichen Modell gehörigen Knoten sowie für zu verschiedenen Modellen gehörigen Knoten jeweils spezifische Evolutionsoperatoren angegeben werden, und der Graph unter Verwendung dieser Evolutionsoperatoren in der Zeit propagiert wird.

## Beschreibung

Die vorliegende Erfindung betrifft ein Verfahren zur computergestützten Simulation technischer Prozesse. Derartige Verfahren werden insbesondere bei Evolutionssimulationsmodellen technischer, insbesondere physikalischer und/oder chemischer Prozesse benötigt, die in der Zeit propagiert werden sollen (Evolution).

Simulationen technischer Prozesse gehen im allgemeinen davon aus, dass mathematische Modelle erstellt werden, mit denen der technologische Prozess approximiert dargestellt wird. Als mathematische Modelle dienen beispielsweise gewöhnliche oder partielle Differentialgleichungen oder Differentialgleichungssysteme. Diese verwenden sog. Diskretisierungseinheiten (Basic Discretization Entities, BDE), die die Lösung dieser Gleichungen der Berechnung mit Hilfe eines Computers zugänglich machen. Dies erfolgt, indem die BDEs auf diskrete Datenstrukturen abgebildet werden und mit Hilfe mathematischer Algorithmen bzw. Operatoren in der Zeit propagiert werden. Die Propagation kann dabei auch zufällige Elemente beinhalten.

Die zusätzliche Abstraktionsebene des erfindungsgemäßen Verfahrens erlaubt eine generische Optimierung der Propagation von Evolutionsproblemen auf verschiedensten Hardware-Architketuren, wobei die Optimierung hinter einer allgemeinen Schnittstelle, die nicht von den speziellen Evolutionsproblemen und nicht von Hardware-Architekturen abhängt, verborgen bleibt. Im Gegensatz dazu sind im Stand der Technik solche Optimierungen auf monolithische Ansätze für spezielle Evolutionsprobleme und spezielle Hardware-Architekturen beschränkt, so dass diese Ansätze immer nur Experten für spezielle Hardware-Architekturen zugänglich sind. Diese Art von Optimierung steht damit weder neuen Evolutionsproblemen noch neuen Hardware-Architekturen generisch zur Verfügung. Meist ist diese aufwendige Optimierungsstrategie auch nicht wirtschaftlich sinnvoll, da erheblicher Aufwand in Wartungs- und Portierungsarbeiten von implementierten Evolutionsproblemen in diesem Ansatz inhärent zu leisten wäre. Die vorliegende Erfindung abstrahiert das notwendige Expertenwissen zur hardwarespezifischen Optimierung und sichert damit die Portierbarkeit bei hoher Performance von verschiedensten Evolutionsproblemen, die nach dem erfindungsgemäßen Verfahren implementiert wurden. Diese neue Optimierung steht auch Nicht-Experten für spezielle Hardware-Architekturen generisch zur Verfügung und stellt einen hohen wirtschaftlichen Vorteil dar.

Der Stand der Technik im Umfeld dieser Offenbarung ist umfassend dargelegt in dem Übersichtsartikel von L. Oliker, et. al., Scientific Computations on Modern Parallel Vectorsystems, Proceedings of the SC2004 conference, Pittsburgh, PA. Generell ist zu konstatieren, dass Simulation von Evolutionsproblemen, implementiert nach dem Stand der Technik auf verteilten und vernetzten Berechnungseinheiten, eine Performance von etwa 5 - 10 % der theoretisch möglichen Peakperformance aufweisen.

Weitere Evolutionsprobleme, die am Fraunhofer ITWM nach dem Stand der Technik implementiert wurden, sind im ParPac Simulationspaket zur Lösung der so genannten Gitter-Boltzmann Gleichung zusammengefasst (Tätigkeitsbericht Institut für Techno- und Wirtschaftmathematik 1999, Seiten 24 - 28, erhältlich bei der Pressestelle des Instituts für Techno- und Wirtschaftmathematik, Gottlieb-Daimler-Straße, 76857 Kaiserslautern. Auch diese Druckschrift wird vollumfänglich in die Offenbarung der vorliegenden Anmeldung aufgenommen). ParPac wurde für vernetzte und verteilte Berechnungseinheiten nach dem Stand der Technik parallelisiert und liefert auf aktuellen Hardware-Architekturen, im Einklang mit dem Stand der Technik, etwa 7 % der theoretischen Peakperformance.

Hier hat sich herausgestellt, dass unter Einsatz der vorliegenden Erfindung in dieser konkreten Anwendung eine Performance-Verbesserung auf aktuellen Hardware-Architekturen um den Faktor 4 erzielt wird. Der wirtschaftliche Vorteil rein aus der Performancesteigerung kann hier sogar qualifiziert werden: für ParPac-Simulationen nach dem Stand der Technik wird, bei gleicher Antwortzeit, ein um den Faktor 4 größeres paralleles Rechnersystem benötigt als unter zusätzlichem Einsatz der vorliegenden Erfindung, was bei tausenden von vernetzten Prozessoren zu erheblich höheren Anschaffungs- und Betriebskosten führt.

Diese Frameworks gemäß dem oben beschrieben Stand der Technik können für ein spezifisches mathematisches Modell variierende Hardwarespezifika sehr spezifisch berücksichtigen. Eine generische Optimierung und gegebenenfalls Parallelisierung der Propagation in der Zeit, die also nicht abhängig ist von der gewählten BDE und dem gewählten mathematischen Modell, wird in diesen Frameworks nicht realisiert.

Bei diesen Ansätzen wird auch durch die Verwendung lediglich einer Sorte BDEs die integrierte Kopplung verschiedener Anwendungen, wie sie etwa in Multiphysics-Simulationen erforderlich ist, von vornherein ausgeschlossen.

Mit der Softwarebibliothek MPCCI existiert zwar die Möglichkeit, verschiedene Finite Elemente-basierte Applikationen miteinander zu koppeln, es existiert jedoch keine Kopplung an andere mathematische Verfahren, die beispielsweise auf Teilchen oder Wavelets basieren. Auch eine integrierte hardwarenahe Optimierung der einzelnen Finite-Element-Löser fehlt in diesem Programmpaket.

Das Programmpaket FEMLAB geht hier einen Schritt weiter, indem allerdings auch wieder lediglich für Finite Elemente-basierte Verfahren, eine Reihe von Kopplungsalgorithmen zur Verfügung gestellt werden. Die einzelnen Verfahren müssen jedoch zwingend auf der Finite-Elemente-Methode beruhen.

Da mit Finiten Elementen jedoch nicht alle technologisch wichtigen Problemstellungen, etwa im Umfeld der Nanotechnologie, modellierbar sind, besteht hier ein Bedarf an neuen Verfahren.

Es ist daher Aufgabe der vorliegenden Erfindung, ein Verfahren zur computergestützten Simulation technologischer Prozesse zur Verfügung zu stellen, das es ermöglicht, verschiedene mathematische Modelle basierend auf verschiedenen Diskretisierungseinheiten miteinander zu verknüpfen und zugleich unabhängig von dem gewählten mathematischen Modell eine hardwarespezifische Optimierung des Rechenprozesses generisch zu verwirklichen.

Diese Aufgabe wird durch das Verfahren nach Anspruch 1 gelöst. Vorteilhafte Weiterbildungen des erfindungsgemäßen Verfahrens, insbesondere auch die generische Parallelisierung von Evolutionsproblemen auf vernetzten Berechnungseinheiten, werden in den jeweiligen abhängigen Ansprüchen gegeben.

Erfindungsgemäß werden mindestens zwei verschiedene mathematische Modelle, die auf unterschiedlichen Diskretisierungseinheiten beruhen, dadurch zu einem gemeinsamen Evolutionsproblem zusammengefasst, dass eine zusätzliche Abstraktionsebene, die den mathematischen Modellen übergeordnet ist, eingeführt wird. Diese Abstraktionsebene besteht aus einem Graphen, auf den die mathematischen Modelle als allgemeine Evolutionsprobleme abgebildet werden. Dabei werden die Diskretisierungseinheiten, wie beispielsweise Finite Elemente, Wavelets oder Teilchen und dergleichen, sowie deren Nachbarschaftrelationen als Knoten sowie Kanten (Links) des Graphen repräsentiert. Sie sind daher die Basiselemente der Geometrie des Evolutionsproblems. Die Evolutionsalgorithmen, die die zeitliche Propagation der Diskretisierungseinheiten sowie ihrer Nachbarschaftsrelationen, also der Knoten und der Kanten beschreiben, werden auf generische Operatoren zurückgeführt. Diese Evolutionsoperatoren werden für die Knoten, die bezüglich der zugeordneten Diskretisierungseinheit einheitlich sind, jeweils generisch und einheitlich zur Verfügung gestellt. Auch für die Kanten des Graphen werden generische Evolutionsoperatoren zur Verfügung gestellt, d.h. für die zwischen Knoten gleicher Diskretisierungseinheit verbindenden Kanten werden jeweils einheitliche Operatoren zur Verfügung gestellt, die dann gleichermaßen auf sämtliche derartigen Knoten angewandt werden. Auch für die Kanten, die verschiedene Diskretisierungseinheiten verbinden und damit verschiedenen mathematischen Modellen zugeordnet sind, werden jeweils generische Evolutionsoperatoren zur Verfügung gestellt, mit denen einheitlich diese Kanten in der Zeit propagiert werden können.

Obwohl das erfindungsgemäße Verfahren den Gesamtgraphen als eine zusätzliche Abstraktionsebene einführt und die Parallelisierung und Optimierung durch generische Operatoren durchgeführt wird, wird wider Erwarten die Simulation erheblich beschleunigt bzw. die erforderliche Rechenleistung verringert.

Während im Stand der Technik versucht wird, durch problemspezifische Algorithmen die vorhandene Rechenleistung optimal zu nutzen, geht also die vorliegende Erfindung den entgegengesetzten Weg und generalisiert das Problem. Dennoch werden in ersten konkreten Anwendungen Leistungssteigerungen um den Faktor 4 beobachtet.

Vorteilhafterweise wird jedem der Knoten und der Kanten ein Kriterium zugeordnet, das die zugehörigen Diskretisierungseinheit bzw. die Art der durch die Kanten verbundenen Knoten charakterisiert. Als Kennzeichen kann beispielsweise eine Farbe gewählt werden. Besteht das gesamte Evolutionsproblem aus zwei mathematischen Modellen, beispielsweise einem Modell basierend auf Finiten Elementen und einem Modell basierend auf Teilchen, so bekommen sämtliche Knoten, die Finite Elemente repräsentieren, eine Farbe, beispielsweise Blau, während sämtliche Knoten, auf die Teilchen abgebildet wurden, beispielsweise die Farbe Rot erhalten. Die Kanten zwischen zwei Knoten, auf die Teilchen abgebildet wurden, sind dann ebenfalls rot, die Farbe der Kanten, die Knoten verbinden, auf die Finite Elemente abgebildet wurden sind dann Blau, während die Farbe derjenigen Kanten, die einen Knoten, auf den ein Finites Element abgebildet wurde, und einen Knoten, auf den ein Teilchen abgebildet wurde, verbinden als zweifarbig blau-rot bezeichnet werden. Dies bedeutet, dass zu jedem Kennzeichen genau eine Diskretisierungseinheit assoziiert wird, wobei die Anzahl der Kennzeichen, und damit die Anzahl der Subevolutionsprobleme (mathematischen Modelle) beliebig groß sein kann. Jede Kante des Graphen tragen also automatisch die zwei Farben der Knoten, die durch die Kante verbunden sind. Damit ergibt sich dann auch eine grundsätzliche Unterscheidung zwischen Intra-Kanten (Intra-Links) innerhalb eines Subevolutionsproblems (einfarbig) und Inter-Kanten (Inter-Links) zwischen zwei unterschiedlichen Subevolutionsproblemen (zweifarbig).

Es ist dabei wesentlich, dass die zwei verschiedenen mathematischen Modelle nicht nur den technischen Prozess in verschiedenen räumlichen oder zeitlichen Bereichen beschreiben können, sondern dass die Modelle auch im gleichen räumlichen und zeitlichen Bereich eines technischen Prozesses nebeneinander existieren können. Dies bedeutet, dass dann für denselben räumlichen und/oder zeitlichen Bereich der technische Prozess durch beide mathematischen Modelle beschrieben wird.

Der Graph muss dabei nicht statisch bleiben, da Knoten die Farbe wechseln können, beispielsweise wenn ein Teilchen aus dem durch ein Molekulardynamik-Modell beschriebenen Bereich in einem Bereich sich bewegt, der durch Finite Elemente beschrieben wird. In diesem Falle wechseln dann auch die Knoten und/oder Kanten die Farbe. Es ist auch möglich, Knoten und/oder Kanten dynamisch zu erzeugen oder zu vernichten.

Die hardwarespezifische Zerlegung und Parallelisierung des Graphen kann nun für den Graphen selbst ohne Kenntnis der in dem Graphen implementierten technischen Prozesse und mathematischen Modelle vorbereitet werden. Die vorliegende Erfindung ermöglicht es also, die Simulationsverfahren auf Hardwarearchitekturen zu optimieren und ermöglicht zugleich die Portierbarkeit auf fundamental andere Architekturen. Der Graph dient dabei als abstrakte Schnittstelle.

Die vorliegende Erfindung ermöglicht es also, den Graphen generisch in einzelne Probleme zu zerlegen und zu partitionieren und dadurch zu parallelisieren, ohne den konkreten technischen Prozess zu kennen. Diese zusätzliche Abstraktionsebene des Graphen ermöglicht also eine generische und automatische Parallelisierung, beispielsweise unter Berücksichtigung der Hardwarespezifika. Die Simulation kann folglich ausgehend von dem Graphen als Verfahren vollständig beschrieben werden, und der Anwender muss lediglich die jeweilige Graphenstruktur in Abhängigkeit von dem von ihm zu simulierenden technischen Prozess festlegen. Hierdurch wird also die konkrete Zerlegung des Problems und Partitionierung bzw. Parallelisierung von dem konkreten Problem und den zu seiner Simulation und Beschreibung verwendeten mathematischen Modellen entkoppelt.

Als Problemzerlegung sind auch mehrere Ebenen einer Zerlegung möglich, so dass neben der problemspezifischen Granularität zusätzlich Hardwarecharakteristika, die als statisch betrachtet werden können, berücksichtigt werden. Dies erlaubt es, die Partitionierung der Größe und Tiefe der Speicherhierarchie, der Verwendung und Verteilung von Shared-Memory-Systemen oder der benutzten Netzwerkverbindung und -topologie anzupassen, wodurch eine hardwarespezifische Optimierung erreicht wird. Wenn sich der Gesamtgraph dynamisch ändert, können auch die statischen Aspekte der Problemzerlegung dynamisch an den neuen Graph angepasst werden, sofern sich daraus eine Leistungsverbesserung des Simulationsverfahrens ergibt. Konkrete Implementierungen dieser Optimierung sind jedoch hardwarearchitekturabhängig.

Weiterhin können verschiedene generische abstrakte Zugriffsmechanismen auf Knoten und/oder Kanten des Graphen bereitgestellt werden und allgemeine Kommunikationsmuster implementiert werden. Die Abstraktion des Graphen ermöglicht auch hier wieder eine architekturspezifische Optimierung, in dem der interne Ablauf dieser Mechanismen auf die Hardware abgestimmt wird. So lassen sich beispielsweise bei jedem Zeitschritt der Berechnung des Evolutionsproblems die Speicherzugriffe durch maximierte Vektorlängen oder Cache-Wiederverwendung (Cache Reuse) reduzieren. Auch die parallelen Kommunikationsmuster können durch einen chromatisch geordneten Kommunikationsgraphen (Kommunikationsmuster), der hier erfindungsgemäß verwendet werden kann, optimiert werden. Ein derartiger chromatisch geordneter Kommunikationsgraph wird in "Peter Klein, Tätigkeitsbericht des Institutes für Techno- und Wirtschaftsmathematik 1999, Seiten 28, 29, erhältlich bei der Pressestelle des Fraunhofer ITWM, Gottlieb Daimler Straße, 76857 Kaiserslautern" beschrieben. Diese Druckschrift wird vollumfänglich in die Offenbarung der vorliegenden Anmeldung aufgenommen.

Die vorliegende Erfindung erlaubt es dem Anwender, beliebige eigene Datenstrukturen und auch Evolutionsoperatoren zu definieren und zu verwenden. Die Implementierung der Parallelisierung bleibt dem Anwender hinter der allgemeinen Schnittstelle, dem Graphen, verborgen, die das Verfahren zur Propagation des Graphen hardwareabhängig und generisch, d.h. von der konkreten Datenstruktur und den konkreten Evolutionsoperatoren unabhängig, implementiert. Die vorliegende Erfindung ist also nicht auf einzelne Verfahren und Problemstellungen beschränkt, sondern allgemein in Simulations- und Evolutionsmodellen einsetzbar. Besondere Vorteile besitzt sie im Bereich der Multiphysics-Simulationsmodelle, bei denen bereichs- und/oder zeitweise verschiedene mathematische Modelle mit verschiedenen Diskretisierungseinheiten verwendet werden.

Die vorliegende Erfindung verwirklicht also eine generische Optimierung auf allen Hardwareebenen angepasst auf architekturspezifische Charakteristika.

So können beispielsweise bei Cache-basierten Maschinen kleine aber immer wieder referenzierte Speicherbereiche bezüglich ihres Cache-Reuse maximiert werden, während bei Rechnern mit Vektorarchitektur eine optimale, d.h. möglichst große Vektorlänge, gewählt werden sollte, um einen hohen Datendurchsatz zu erzielen.

Besonders vorteilhaft kann bei Verwendung eines Computers mit einem n-fach assoziativen L2-Cache-Speicher die Nutzung der Speicherhierarchien optimiert werden, indem der Graph in einzelne Subgraphen zerlegt wird und die einzelnen Subgraphen im Hauptspeicher jeweils etwa bzw. genau in der Größe eines der n Speicherbereiche (L2-Blöcke) gespeichert werden. Anschließend werden sämtliche Knotenoperatoren und Linkoperatoren (Propagationen der Knoten und Kanten), die auf denselben Speicherbereich zugreifen, möglichst blockweise direkt hintereinander ausgeführt. Es werden also zuerst sämtliche Knotenoperatoren und dann sämtliche Linkoperatoren, die auf denselben Speicherbereich zugreifen, ausgeführt, woraufhin zu den Knotenoperatoren und Linkoperatoren übergegangen wird, die auf den nächsten Speicherbereich zugreifen. Auf diese Weise ist es möglich, den Cache-Speicher optimal zu nutzen. Im Stand der Technik war es bisher üblich, zuerst sämtliche Knotenoperatoren durchzuführen und dann erst sämtliche Linkoperatoren. Demgegenüber führt das erfindungsgemäße logische Pipelining zu einer erheblich verbesserten Leistung bei gleich bleibender Hardwarespezifikation.

Dieses Verfahren, hier beschrieben für einen L2-Cache-Speicher, kann entsprechend auch auf andere Speicherhierarchien (Cachehierarchien) angewandt werden. Im Falle von mehreren (k ist eine natürliche Zahl) Cache-Speicher-Ebenen kann die Unterteilung in Subgraphen also so vorgenommen werden, dass jeder Subgraph im Hauptspeicher jeweils in einem Speicherbereich gespeichert wird, dessen Größe der Größe eines Speicherblocks eines der k Cache-Speicher entspricht. Weist die Cachehierarchie also k Speicher-ebenen auf, so kann zur Optimierung beispielsweise die m-te Speicherebene gewählt werden. Ist diese durch einen n-fach assoziativen Speicher mit n Speicheblöcken realisiert, wobei jeder Speicherblock eine Größe von x kByte aufweist, so wird der Graph in Subgraphen so unterteilt, dass jeder Subgraph im Hauptspeicher einen Speicherbereich von x kByte belegt. Es genügt jedoch auch bereits, jeden Subgraphen im Hauptspeicher in einem Speicherbereich mit etwa bzw. annähernd, jedoch nicht exakt x kByte zu speichern, um eine Leistungsverbesserung zu erreichen. Bei mehr als zwei Cache-Hierarchieebenen (k > 2) kann durch Auswahl der geeigneten m-ten Speicherebene das erfindungsgemäße Verfahren optimiert werden.

Mit dem erfindungsgemäßen Verfahren, insbesondere unter Verwendung der oben beschriebenen chromatisch geordneten Kommunikationsmuster, kann auch eine konfliktfreie Taskbearbeitung verschiedener parallel arbeitender Prozessoren erzielt werden. Dead-Locks und Congestion können folglich vermieden werden. Zusätzlich sorgt die Möglichkeit, Kommunikationsthreads transparent zu benutzen für eine Asynchronität zwischen Berechnung auf einem SMP-Knoten und Kommunikation zwischen diesen SMP-Knoten und damit für eine optimale Nutzung von Hardwareparallelitäten. Weitere vorteilhafte Implentierungsstrategien werden in der nachfolgenden Tabelle gegeben.

| Architektur | Hardware-charakteristika | Anforderung an Implementierung | Erfindungsgemäße Policy |
|---|---|---|---|
| Vektormaschinen | Vektor-Pipelines | Optimale Vektorlängen | Allokator Policy für Links und Knoten |
| | | Datenlokalität bei dynamischen Graphen beibehalten | Knoten- und Linkdaten umspeichern |
| Multicore Architekturen | Ein Code- und Daten-Hauptspeicher <-> | Optimale Speicherblockgrößen | Datenspeicher und Codespeicher müssen aufeinander angepasst sein. |
| | viele Core Prozessor Speicher | Reuse | Applikationsabhängig: Daten-Reuse -> Code-Pipelining Code-Reuse -> Daten-Pipelining |
| Bsp. Cell | 1 DMAC und 8 Vektor-Einheiten | Konfliktfreies Loading von Daten und/oder Algorithmen | Queueing |

Im Folgenden wird anhand von Figuren das erfindungsgemäße Verfahren beschrieben.

Es zeigen
- Figur 1: einen erfindungsgemäßen Graphen;
- Figuren 2a bis 2c: die Parallelisierung eines Graphen;
- Figur 3: die Zerlegung eines Graphen;
- Figur 4: die Optimierung der Cache-Nutzung durch das erfindungsgemäße Verfahren;
- Figur 5: die Ergebnisse des erfindungsgemäßen Verfahrens unter Verwendung eines vierfach assoziativen L2-Cache-Speichers;
- Figuren 6 bis 8: den Pseudocode für das erfindungsgemäße Verfahren zur Implementierung auf einem Computer;

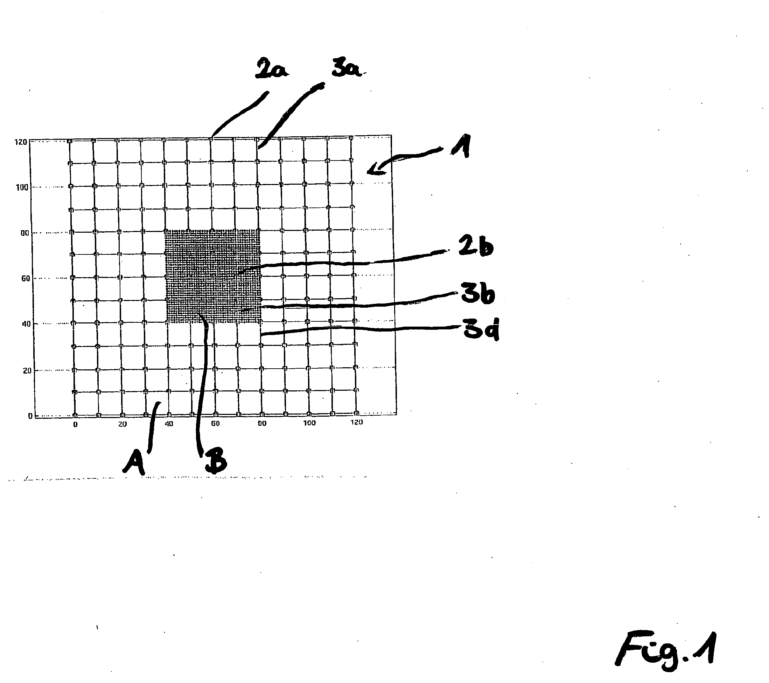

Figur 1 zeigt einen erfindungsgemäßen Graphen einer Multiphysics-Anwendung gemäß der vorliegenden Erfindung.

In einem ersten physikalischen Rechengebiet A (hell dargestellt) wird zur Simulation des physikalischen Problems die Finite-Elemente-Methode verwendet, um eine kontinuumsmechanische Beschreibung des Verhaltens eines Materials zu implementieren. In einem zweiten Rechengebiet B (grau unterlegt) wird die sog. Molekulardynamik verwendet, um Atome in der Zeit zu propagieren. In dem Bereich A werden also als Diskretisierungselement Finite Elemente verwendet, während in dem Bereich B als Diskretisierungselement Teilchen verwendet werden. Die Teilchen besitzen als Daten ihre Koordinaten, Geschwindigkeiten sowie eine Teilchenkennung. Die Koordinaten werden mit Hilfe der Geschwindigkeit in der Zeit propagiert. Hierfür wird als Evolutionsoperator ein Knotenoperator implementiert. Die Geschwindigkeiten werden mit Kräften propagiert, wobei die Kräfte von benachbarten Atomen abhängen. Dies wurde als Linkoperator implementiert.

Im Bereich A der Finiten Elemente besteht die Diskretisierungseinheit aus einem Finiten Element, wobei die Verschiebung des Finiten Elements mit Hilfe von Standardverfahren, die als Knoten- und Kantenoperatoren der Finiten Elemente implementiert sind, gelöst werden.

Für den Kopplungsbereich, der durch einen Intergraphen abgebildet wird, werden spezifische Operatoren definiert, die das Verhalten eines Finiten Elementes in das Verhalten eines Teilchens umschreiben bzw. umkehrt.

In Figur 1 sind also die Finiten Elemente 2a, die Diskretisierungseinheiten des Bereichs A, die über Intra-Links (Intra-Knoten) 3a miteinander verbunden sind. Die Teilchen 2b im Bereich B werden durch Intra-Knoten 3b untereinander verbunden. Die Verbindung zwischen den Teilchen 2b und den Finiten Elementen 2a erfolgt über Inter-Links (Inter-Knoten) 3c.

Hier ist zu beachten, dass die Bereiche A und B nicht unbedingt räumlich verschiedene Bereiche sein müssen. Diese können auch lediglich zeitlich verschiedene Bereiche sein oder auch überlappende oder gar deckungsgleiche Bereiche. In letzterem Fall wird der technische Prozess dann doppelt durch zwei verschiedene mathematische Modelle beschrieben.

Werden Kennzeichen für die einzelnen Knoten und Kanten verwendet, so kann in Figur 1 beispielsweise den Knoten 2a und den Kanten 3a die Farbe Rot zugeordnet werden, den Knoten 2b und den Kanten 3b die Farbe Blau, während die Kanten 3c rot-blau bzw. blau-rot sind. Anstelle von Farben sind jedoch auch jede andere Art von Kennzeichen möglich. Farben eignen sich jedoch besonders gut zur intuitiven Darstellung der unterschiedlichen Bereiche eines Gesamtgraphen 1.

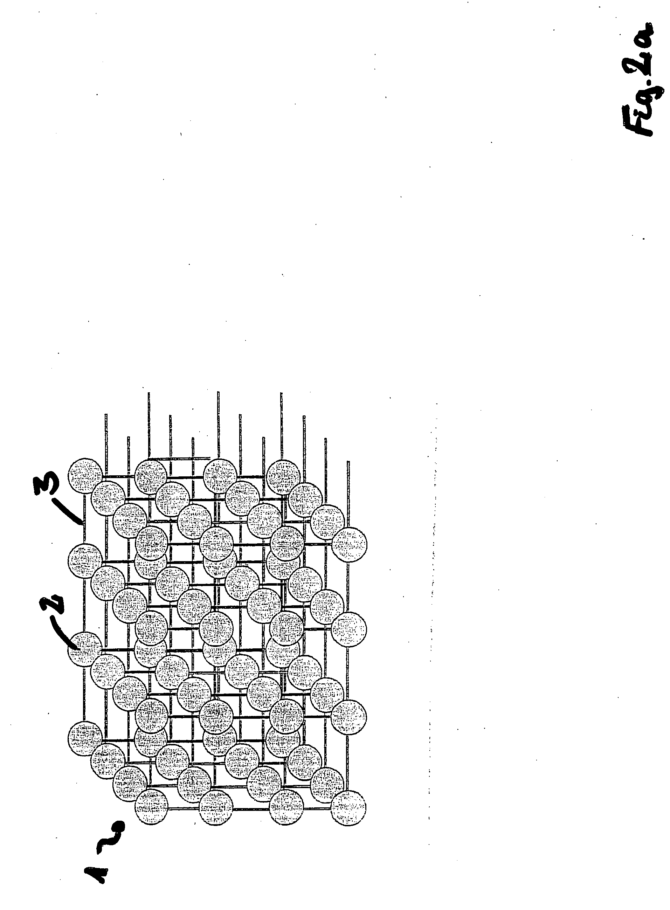

Die Figuren 2A bis 2C zeigen die Schritte, die bei der Parallelisierung des Graphen 1 durchgeführt werden, nachdem die Geometrie und die Algorithmen der mathematischen Modelle, so wie in Figur 1 gezeigt, auf den Graphen 1 abgebildet wurden.

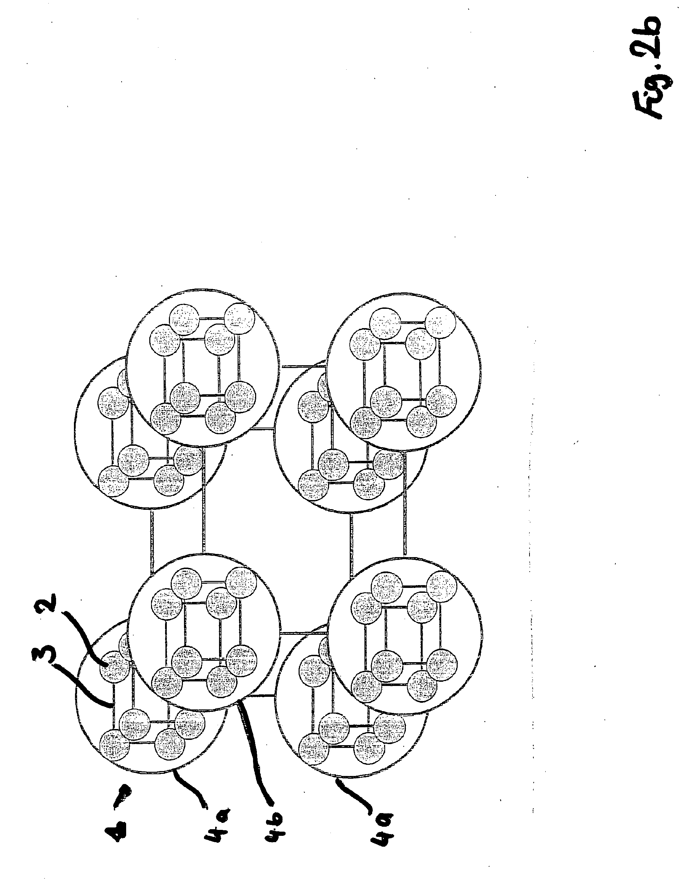

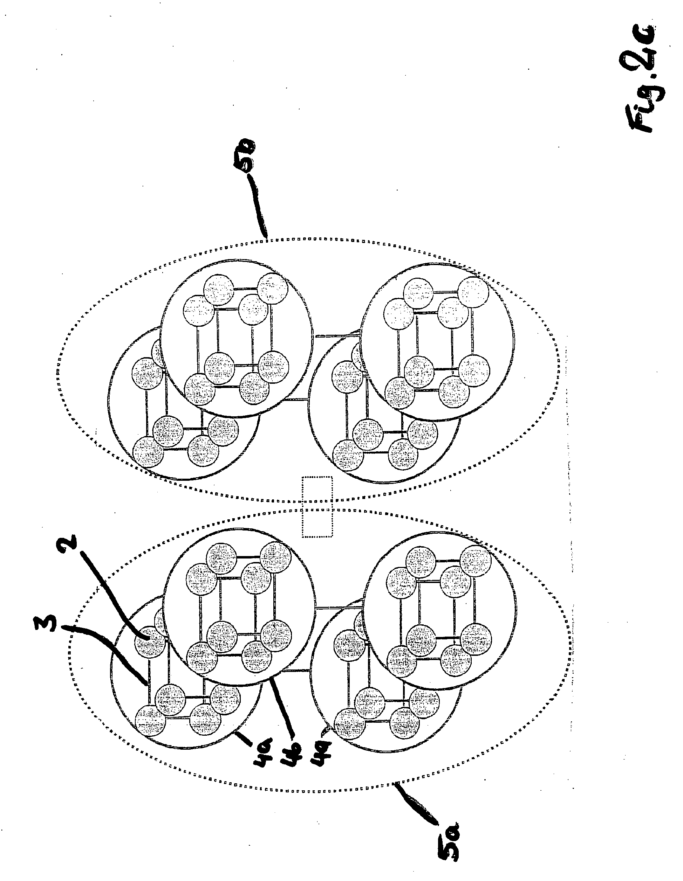

Zuerst folgt eine Partitionierung des Graphen 1 in einzelne Bereiche 4a, 4b und 4c (siehe Figur 2b) und anschließend eine Aufteilung der einzelnen Graphenbereiche 4a, 4b und 4c auf einzelne Berechnungseinheiten (Prozessoren). Die Graphenbereiche, die jeweils einem Prozessor zugeordnet sind, sind in Figur 2c durch gestrichelte Linien verbunden und mit den Bezugszeichen 5a bzw. 5b bezeichnet.

Für diese Bereiche 5a bzw. 5b werden dann anschließend in paralleler Weise die Berechnung zur Propagation der Graphenbereiche 4 durchgeführt. Dies erfolgt über generische, d.h. vom konkreten zu simulierenden technologischen Prozess unabhängigen Schleifen über die Knoten und Kanten des Graphen 1.

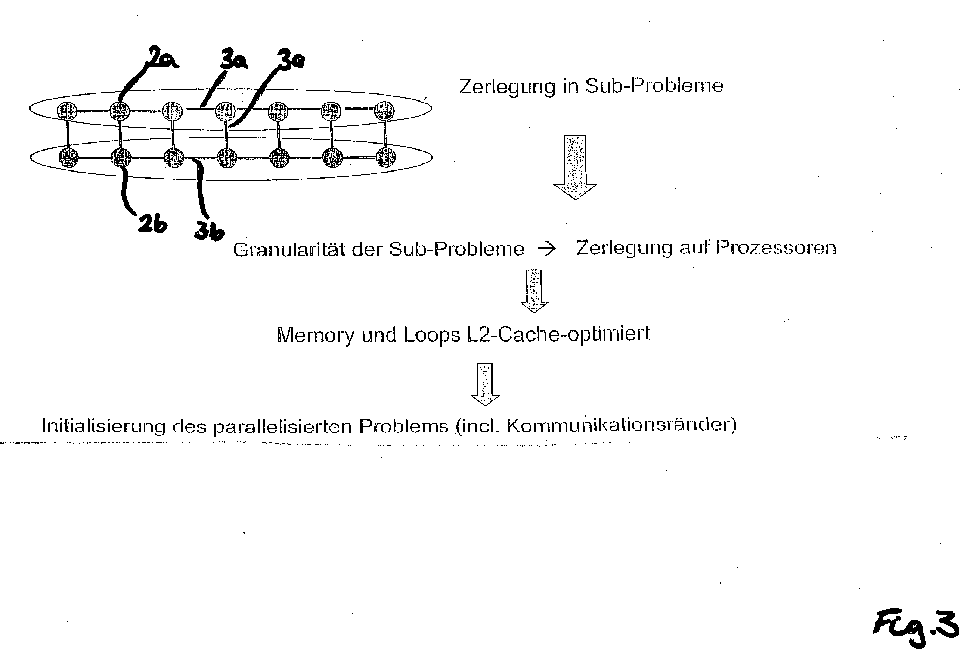

Figur 3 zeigt die Zerlegung in Subprobleme, wobei hier ein Graph dargestellt ist, der Knoten 2a und 2b verschiedener Diskretisierungseinheiten darstellt. In diesem Beispiel erfolgt die Zerlegung des Gesamtgraphen in Subprobleme und anschließend eine weitere Zerlegung auf die Prozessoren. Bei der Zerlegung auf die Prozessoren und der Zerlegung in die Subprobleme kann die Hardware berücksichtigt werden und so beispielsweise die Speichernutzung und die Schleifen an einen vorhandenen L2-Cache-Speicher angepasst werden. Zuletzt wird dann das parallelisierte Problem initialisiert und berechnet und so der technische Prozess simuliert.

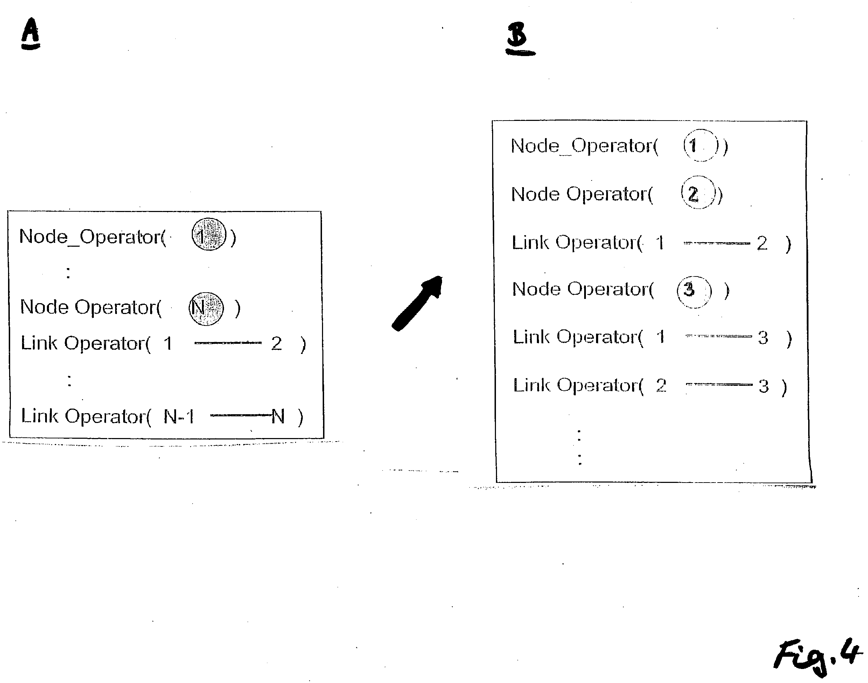

Figur 4 zeigt die logische Pipeline, die für einen n-fach assoziierten L2-Cache-Speicher optimiert wurde. Statt wie in Figur 4A und im Stand der Technik üblich bei jedem Evolutionsschritt zuerst sämtliche Knoten zu propagieren (Note_Operator(.)) und erst dann sämtliche Kanten zu propagieren (Link Operator(.)) wird nunmehr wie in Figur 4 dargestellt eine andere Vorgehensweise gewählt. Hierzu werden in jeweils einen Speicherbereich die Informationen für einen Graphenabschnitt, beispielsweise 4a in Figur 2C gespeichert und anschließend werden sämtliche Knoten und Kanten dieses Graphenbereiches propagiert. Es erfolgt also hierbei vornehmlich ein Zugriff auf die Informationen in einem Speicherbereich des Cache-Speichers. Erst anschließend werden die Knoten und Kanten propagiert, für deren Propagation ein Zugriff auf den zweiten Bereich des Cache-Speichers benötigt wird. Die Nutzung des Cache-Speichers wird hierdurch optimiert.

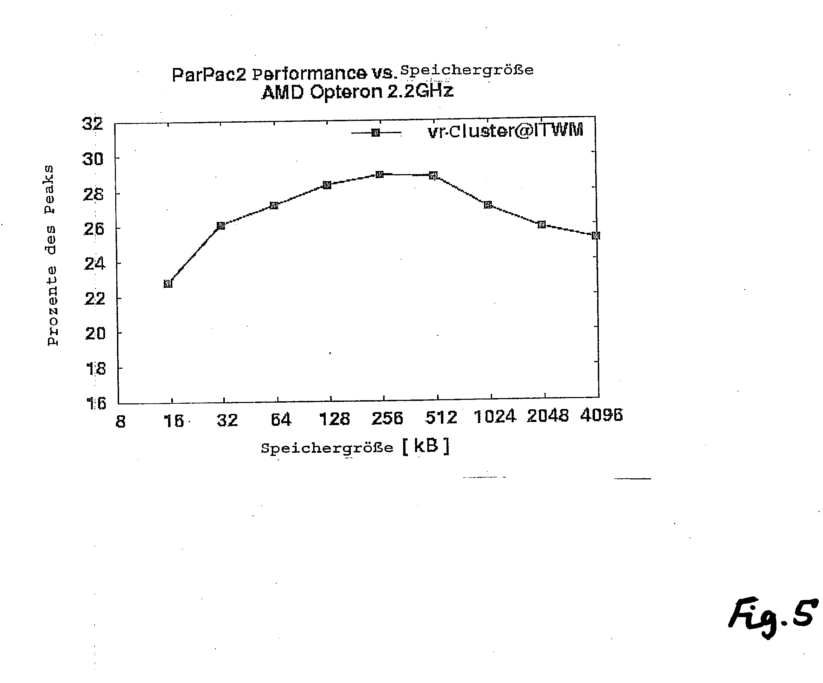

Figur 5 zeigt die Ergebnisse, die durch dieses Vorgehen erzielt werden. Bei einem vierfach assoziativen L2-Cache-Speicher (mit einer Speicherblockgröße von 256 kB) wurden jedem Subgraphen im Hauptspeicher eine Speichergröße (Container Size) von 256 kB zugeordnet, wobei dann, wie für Figur 4 beschrieben, von dem jeweiligen Prozessor zuerst sämtliche Knoten und Kanten, deren Propagation ihm zugewiesen wurde und für die die erforderlichen Informationen in dem zugeordneten Container (Speicherblock) gespeichert waren, berechnet wurden. Erst abschließend wurde dann die Propagation des Gesamtgraphes ermittelt. Wie in Figur 5 zu erkennen ist, ergibt sich bei der Containergröße von 256 kB, die genau einem Speicherbereich des vierfach assoziativen L2-Cache-Speichers von 1024 kB entspricht, eine optimale Leistung verglichen mit Containergrößen, die geringer oder größer sind. Das erfindungsgemäße Verfahren bewirkt also einen sehr effizienten Ressourceneinsatz bei Verwendung eines L2-Cache-basierten Rechnersystems.

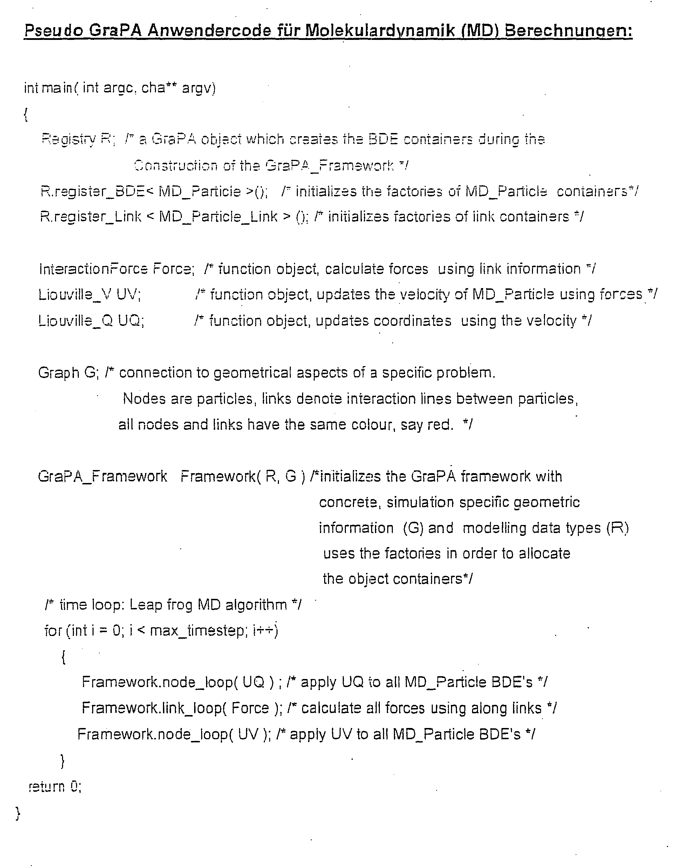

Die Figuren 6 bis 8 zeigen nun den Pseudocode zur Initialisierung und Verwendung des erfindungsgemäßen Verfahrens.

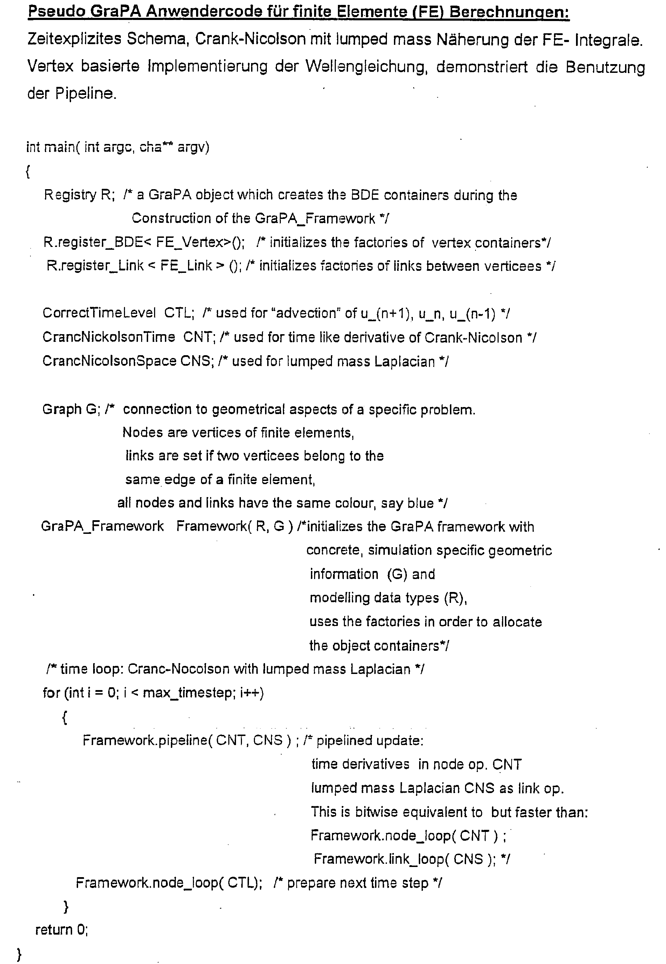

In Figur 6 wird die Verwendung des Verfahrens lediglich mit einem mathematischen Modell, hier der Molekulardynamik, gezeigt. In Figur 7 erfolgt ebenfalls die Verwendung lediglich eines mathematischen Modells unter Verwendung von Finiten Elementen als Diskretisierungseinheit.

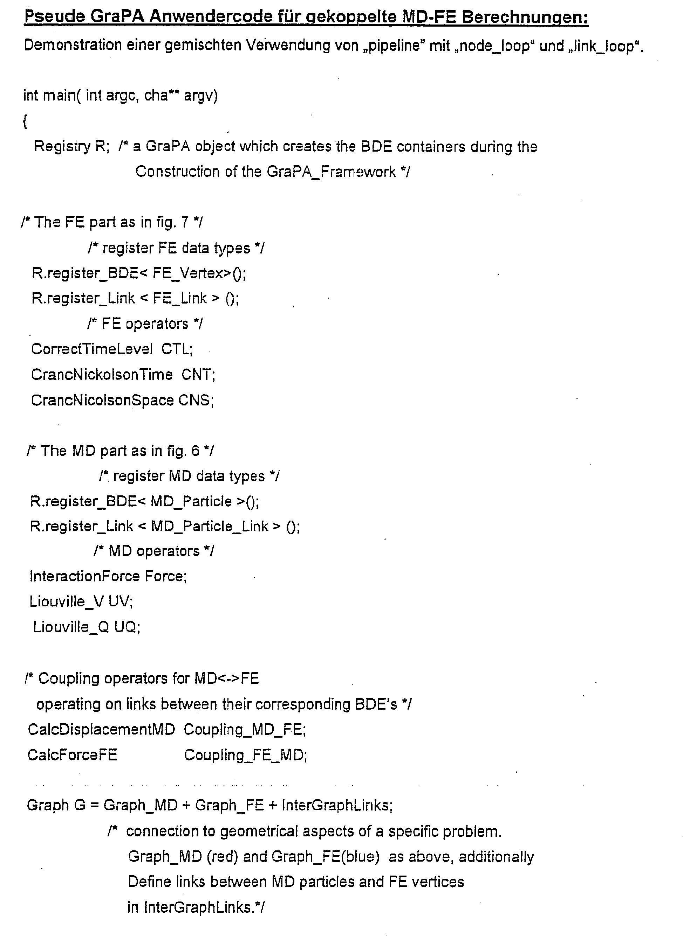

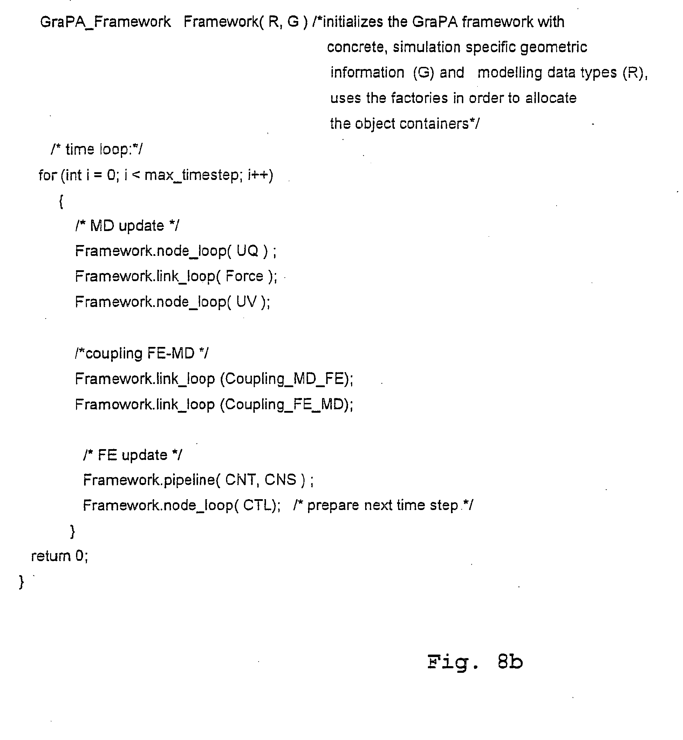

Figur 8A und 8B, die fortlaufend gelesen werden müssen, verbindet nun diese beiden Elemente aus den Figuren 6 und 7 zu einem erfindungsgemäßen Verfahren.

In Figur 6 werden zuerst mit R.register_BDE die Knoten und mit R.register_Link die Kanten des Graphen angelegt, die ein Molekulardynamik-Modell abbilden sollen. Weiterhin werden mit InteractionForce Force, Liouville_V UV und Liouville_Q UQ die Propagationsroutinen für die Berechnung der Kräfte zwischen den einzelnen Knoten, für die Propagation der Geschwindigkeit V sowie die Propagation der Koordinaten Q der Knoten festgelegt. Diese allgemeinen Routinen (Propagationsoperatoren) gelten für sämtliche Knoten und Kanten vom Typ MD (zugehörig zum Molekulardynamik-Modell).

Mit dem in dem Pseudocode angedeuteten Time Loop wird dann die Propagation durchgeführt, indem die oben genannten Propagationsoperatoren für jeweils einen Zeitabschnitt auf sämtliche Knoten und Kanten angewandt werden.

Figur 7 zeigt dasselbe System für Finite Elemente als Diskretisierungseinheit. Auch hier werden wiederum über R.register_BDE und R.register_Link die Knoten und Kanten des Graphen festgelegt, die das Finite-Elemente-Modell abbilden.

Für die Propagation des Finite-Elemente-Modells werden nun die Propagationsoperatoren CorrectTimeLevel CTL, CrancNicolsonTime CNT sowie CrancNicolsonSpace CNS definiert.

Auch hier erfolgt die Propagation in dem in Figur 7 befindlichen "Time Loop", indem die genannten drei Propagationsoperatoren auf sämtliche Knoten und Kanten angewandt werden.

Das erfindungsgemäße Verfahren, wie es in den Figuren 8a und 8b gezeigt ist, kombiniert nun beide Modelle und stellt zuerst einen Graphen zur Verfügung, in dem die Kanten und Knoten des Finite-Elemente-Modells sowie die Kanten und Knoten entsprechend dem Molekulardynamikmodell definiert werden. Für jedes der Modelle werden wiederum die entsprechenden Propagationsoperatoren (Propagationsfunktionen) wie in den Figuren 6 und 7 definiert.

Zusätzlich werden jetzt noch Verknüpfungsoperatoren definiert, die miteinander über Kanten verbundene Knoten des Molekulardynamik-Teilgraphen und des Finite-Elemente-Teilgraphen miteinander koppeln. Dies erfolgt einmal als Operator, der aus dem Molekulardynamikmodell die Verschiebung des benachbarten Finiten Elementes berechnet (CalcDisplacementMD) und andererseits einen Operator, der aus dem Finite-Elemente-Modell, die auf ein Teilchen im Molekularteilchenmodell wirkende Kraft berechnet (CalcForceFE).

Damit hat der Anwender dann den Graphen vollständig definiert, und der Graph wird dann anschließend in der Zeit propagiert (siehe Abschnitt "Time Loop", in dem die genannten Propagationsoperatoren und Kopplungsoperatoren auf die Knoten und Kanten entsprechend ihrer jeweiligen Eigenschaft angewandt werden.

## Patentansprüche

1. Verfahren zur computergestützten Simulation der zeitlichen Propagation technischer Prozesse als Evolutionsproblem, das durch mindestens zwei verschiedene mathematische Modelle als Subevolutionsprobleme beschrieben wird, die voneinander verschiedene, mittels modellspezifischer Algorithmen in der Zeit propagierte Diskretisierungseinheiten verwenden,
wobei die Simulation mittels einer Vielzahl von Berechnungseinheiten ausgeführt wird,
**dadurch gekennzeichnet, dass** die mathematischen Modelle als Subevolutionsprobleme auf eine einzige zusammenhängende Graphenstruktur (1) mit den Diskretisierungseinheiten als Knoten (2) und deren Nachbarschaftsrelationen als Kanten (3) abgebildet werden,
wobei sich eine Unterscheidung zwischen Kanten (3a, 3b) innerhalb eines Subevolutionsproblems und Kanten (3c) zwischen zwei unterschiedlichen Subevolutionsproblemen ergibt,
jeweils für die jeweils einem mathematischen Modell als Subevolutionsproblem zugeordneten Knoten, für die Kanten (3a,3b) zwischen zum gleichen Modell als Subevolutionsproblem gehörigen Knoten sowie für die Kanten zwischen zu verschiedenen Modellen als Subevolutionsproblemen gehörigen Knoten jeweils spezifische Evolutionsoperatoren angegeben werden,
und der Graph unter Verwendung dieser Evolutionsoperatoren in der Zeit propagiert wird.

2. Verfahren nach dem vorhergehenden Anspruch, **dadurch gekennzeichnet, dass** sich Kanten (3a, 3b) zwischen zum gleichen Model gehörigen Diskretisierungseinheiten sowie Kanten (3c) zwischen zu verschiedenen Modellen gehörigen Diskretisierungseinheiten ergeben.

3. Verfahren nach einem der vorhergehenden Ansprüche, **dadurch gekennzeichnet, dass** die Simulation optimiert und/oder parallelisiert mittels der Vielzahl von Berechnungseinheiten ausgeführt wird.

4. Verfahren nach einem der vorhergehenden Ansprüche, **dadurch gekennzeichnet, dass** jedem Knoten (2a, 2b) ein Kennzeichen zugeordnet wird, das den Typ der durch ihn abgebildeten Diskretisierungseinheit angibt.

5. Verfahren nach einem der vorhergehenden Ansprüche, **dadurch gekennzeichnet, dass** jeder Kante (3a, 3b, 3c) ein Kennzeichen zugeordnet wird, das den Typ der beiden Diskretisierungseinheiten bezeichnet, die auf die durch die Kante verbundenen Knoten abgebildet wurden.

6. Verfahren nach einem der vorhergehenden Ansprüche, **dadurch gekennzeichnet, dass** die Propagation des Graphen als Evolutionsproblem unabhängig von dem auf den Graphen abgebildeten Evolutionsproblem parallelisiert wird.

7. Verfahren nach einem der vorhergehenden Ansprüche, **dadurch gekennzeichnet, dass** die Parallelisierung die folgenden Schritte enthält:
Partitionierung des Graphen (1) in Teilgraphen (4a, 4b, 4c),
Zuordnung eines oder mehrerer Teilgraphen (4a, 4b, 4c) zu einzelnen Berechnungseinheiten (5a, 5b),
Berechnung der Propagation der Teilgraphen (4a, 4b, 4c) durch die Berechnungseinheiten unter Verwendung der Evolutionsoperatoren, und
Zusammenfügen der Berechnungsergebnisse zur Berechnung der Propagation des Graphen (1).

8. Verfahren nach dem vorhergehenden Anspruch, **dadurch gekennzeichnet, dass** das Verfahren auf einem Computer mit k Cachespeicherebenen mit mindestens einem n-fach assoziativen Cachespeicher mit n Speicherbereichen durchgeführt wird, wobei k und n natürliche Zahlen sind.

9. Verfahren nach dem vorhergehenden Anspruch, **dadurch gekennzeichnet, dass** der Graph (1) derart in Teilgraphen (4a, 4b, 4c) partitioniert wird, dass jeder Teilgraph in einem Speicherbereich gespeichert wird, dessen Größe der Größe eines der n Speicherbereiche eines der Cache-Speicher weitgehend bzw. genau entspricht.

10. Verfahren nach dem vorhergehenden Anspruch, **dadurch gekennzeichnet, dass** die Propagation sämtlicher Knoten (2a, 2b) und Kanten (3a, 3b, 3c), zu deren Propagation Daten aus demselben Speicherbereich im Hauptspeicher verwendet werden, zeitliche zusammenhängend berechnet wird.

11. Verfahren nach einem der Ansprüche 9 bis 11, **dadurch gekennzeichnet, dass** die Propagation der Knoten (2a, 2b) und Kanten (3a, 3b, 3c), zu deren Propagation Daten aus einem ersten Speicherbereich des Hauptspeichers verwendet werden, zeitlich zusammenhängend berechnet wird und anschließend die Propagation sämtlicher Knoten (2a, 2b) und Kanten (3a, 3b, 3c), zu deren Propagation Daten aus einem zweiten Speicherbereich des Hauptspeichers verwendet werden, zeitlich zusammenhängend berechnet wird.

12. Verfahren nach einem der Ansprüche 9 bis 12, **dadurch gekennzeichnet, dass** das Verfahren auf einem Computer mit n-fach assoziativen Level-2-Cachespeicher (k=2) durchgeführt wird und der Graph (1) derart in Teilgraphen (4a, 4b, 4c) partitioniert wird, dass jeder Teilgraph einen Speicherbereich im Hauptspeicher belegt, dessen Größe der Größe eines Speicherblocks des Level-2-Cachespeichers weitgehend oder genau entspricht.
